(19) **Europäisches Patentamt European Patent Office Office européen des brevets**

(11) **EP 2 726 997 B1**

(12) **EUROPEAN PATENT SPECIFICATION**

(45) Date of publication and mention
of the grant of the patent:
**06.04.2016  Bulletin 2016/14**

(51) Int Cl.:
***G06F 13/40*** *(2006.01)*

(21) Application number: **12733000.9**

(22) Date of filing: **20.06.2012**

(86) International application number:
**PCT/EP2012/061868**

(87) International publication number:
**WO 2013/004504 (10.01.2013 Gazette 2013/02)**

(54) **BROADCAST SERIAL BUS TERMINATION**

ABSCHLUSS FÜR BROADCAST-SERIENANSCHLUSS

TERMINAISON DE BUS EN SÉRIE DE DIFFUSION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **01.07.2011  EP 11172397**

(43) Date of publication of application:
**07.05.2014  Bulletin 2014/19**

(73) Proprietor: **Siemens Aktiengesellschaft
80333 München (DE)**

(72) Inventor: **KRISTIANSEN, Karstein
7051 Trondheim (NO)**

(56) References cited:
**WO-A1-98/19430      DE-A1- 10 261 386
DE-A1- 19 854 117**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF THE INVENTION

The invention relates to a broadcast serial bus termination circuit and to a subsea node comprising such circuit. Furthermore, a subsea broadcast serial bus system and a method of terminating a broadcast serial bus are provided.

BACKGROUND

For enabling devices to communicate with each other, bus systems are often used. A known system is for example the controller area network (CAN) bus which is frequently used in automotive applications, but also in industry automation. Several nodes that are capable of sending and receiving messages are connected to the bus, such as controllers, sensors or actuators. A node connected to the CAN bus may for example comprise a processing unit processing e.g. sensor data, a CAN-controller which compiles messages to be transmitted on the bus or decodes received messages, and a transceiver which generates the electric signals by means of which the message is transmitted on the CAN bus.

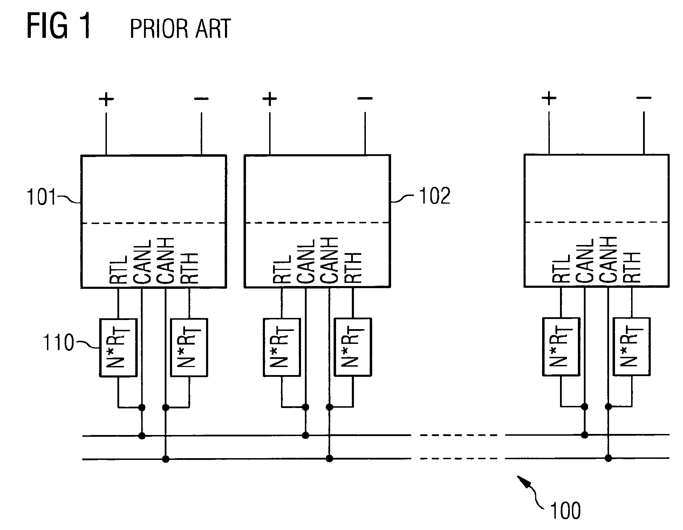

Figure 1 illustrates a CAN bus 100 to which a number of N nodes 101, 102, ... are coupled. Each CAN node is locally powered. The CAN bus 100 is to be operated with a predetermined termination impedance ($R_T$). To achieve this impedance on the bus, each node 101, 102, ... comprises a termination impedance 110 having a resistance value of $N* R_T$. If N nodes are connected to the bus, the total bus impedance will thus be $R_T$, as desired.

The document DE 102 61 386 A1 describes a device for terminating a two wire connection. A control logic is provided that can select to activate a termination resistance or to separate it from the bus.

The document DE 198 54 117 A1 describes a switching configuration for providing communication for plural electrical components in a vehicle. An external device or a dedicated control device is used to adjust the impedances of the electrical components.

A problem arises if nodes are to be added to or if nodes are to be removed from the bus. The bus impedance can change and an impedance mismatch on the CAN bus can result.

This may be a particular problem in a subsea environment, in which the bus and the nodes connected thereto are inaccessible. If a node is disconnected from the bus, e.g. due to failure of the node, the bus impedance will change, which may be detrimental to a reliable operation of the remaining nodes. Consequently, the communication between the different nodes may be disturbed and the whole system may need to be serviced, which is time and cost intensive.

It is thus desirable to enable the connecting/disconnecting of nodes to the bus without compromising the functionality of the bus. In particular, it is desirable to avoid impedance mismatches, which may result in signal reflections and may degrade system operability.

SUMMARY

Accordingly, there is a need to obviate at least some of the drawbacks mentioned above and to improve the flexibility of a multidrop serial bus with respect to the number of connected nodes.

This need is met by the features of the independent claims. The dependent claims describe embodiments of the invention.

An embodiment provides a broadcast serial bus termination circuit for a broadcast serial bus which is adapted to have a variable number of nodes connected thereto. The nodes can be connected in parallel to a first signal line and a second signal line of the broadcast serial bus, with each node connecting the first signal line to the second signal line via a node impedance. The broadcast serial bus is to be operated with a predetermined bus impedance. The broadcast serial bus termination circuit comprises an adjustable impedance that is, in operation, connected between the first signal line and the second signal line of the broadcast serial bus. It further comprises an adjusting unit adapted to a just the adjustable impedance. The adjusting unit is configured to enable an adjustment of the adjustable impedance in dependence on the number of nodes connected to the broadcast serial bus. It is further configured to be capable of adjusting the adjustable impedance such that for different numbers of nodes connected to the broadcast serial bus, the total impedance of the broadcast serial bus corresponds to the predetermined bus impedance.

If nodes are disconnected from or connected to the broadcast serial bus, the termination circuit may thus keep the total impedance of the broadcast serial bus substantially constant. If the node impedances are connected in parallel across the first and second signal lines of the broadcast serial bus, the removal of a node will increase the total bus impedance.

Accordingly, the adjusting unit may be configured to decrease the value of the adjustable impedance in such case, so that the total impedance of the broadcast serial bus also decreases, so that the predetermined bus impedance is reached. The termination circuit may thus make the connecting and disconnecting of units from the broadcast serial bus more flexible, which can be particularly advantageous in subsea environments where nodes of the broadcasts serial bus are not easily accessible. The adjustable impedance may be adjusted by setting a resistance value of the adjustable impedance. The resistance value may be controlled by the adjusting unit.

In an embodiment, the adjustable impedance is adapted to be adjustable to integer fractions of the node impedance. The node impedance of each node may for example be N x $R_T$, wherein N is the maximum number of connectable nodes, and wherein $R_T$ is the predetermined bus impedance. The adjustable impedance may thus be adjustable to resistance values of an integer fraction of N x $R_T$. The fraction may for example be the number of disconnected nodes + 1 (i.e. if no node is disconnected, the adjustable impedance is N x $R_T$). The termination circuit may thus be capable of adjusting the actual bus impedance to the predetermined bus impedance for any number of connected nodes up to the maximum node number N. The termination circuit can be part of a node having the adjustable impedance as a node impedance.

In an embodiment, the adjustable impedance comprises a voltage controlled resistance. The resistance value of the adjustable impedance may thus be controlled by applying a corresponding control voltage. An automatic adjustment of the adjustable impedance thus becomes feasible, although it is possible to manually adjust the control voltage, or to preset the control voltage, e.g. by means of a software user interface.

The adjustable impedance may comprise a field effect transistor. In particular, it may comprise a JFET (junction gate field effect transistor). The field effect transistor may be operated as a voltage controlled resistance. The adjustable impedance can thus be adjusted to different resistance values in a simple way. In a further embodiment, the adjustable impedance may comprise a resistor ladder. As mentioned above, the resistances in the resistance ladder may have steps that correspond to an integer fraction of the node impedance, such that the adjustable impedance is adjustable in the corresponding steps. The resistance ladder network may have switches that may be manually switched or may be electronically switched. In an embodiment, the adjusting unit may comprise a controller that is adapted to control the value of the adjustable impedance, in particular its resistance value. Such controller may for example provide a control voltage to a voltage controlled resistance, or may switch the electronic switches of a resistor ladder. This may enable an automatic control of the adjustable impedance, or a remote manual control, e.g. via a software interface from a topside control center.

The controller may for example comprise a micro controller. It may be part of a node comprising the broadcast serial bus termination circuit.

In an embodiment, the adjusting unit may comprise mechanical switches configured such that by actuation of the mechanical switches, different values of the adjustable impedance are selectable. It may for example comprise dip switches, by which the adjustable impedance can, staring at a maximum value, stepwise be reduced. By means of the mechanical switches, the total bus impedance may be configured for a particular number of connected nodes. The mechanical switches may for example be used for switching the resistances of a resistor ladder. Note that mechanical switches may also be electronically controlled by means of a controller, such as mechanical relays. In such a configuration, galvanic isolation maybe achieved, while enabling a precise selecting of the different resistance values of the adjustable impedance.

In an embodiment, the broadcast serial bus termination circuit is configured to be capable of adjusting the total impedance of the broadcast serial bus to match the predetermined bus impedance for any number of nodes connected to the broadcast serial bus up to a predetermined maximum number (N) of nodes. The broadcast serial bus termination circuit may thus be constructed for a particular maximum node number, which can be selected high enough so as to an enable a flexible broadcast serial bus configuration.

According to the invention, a subsea node for a broadcast serial bus is provided, wherein broadcast serial bus has a variable number of nodes connected thereto, the nodes being connected in parallel to a first signal line and a second signal line of the broadcast serial bus. Each node connects the first signal line to the second signal line via a node impedance. The broadcast serial bus is to be operated with a predetermined bus impedance. The subsea node comprises a broadcast serial bus termination circuit according to any of the above mentioned configurations. The broadcast serial bus termination circuit is, in operation, connected to the first and second signal lines.

Such subsea node may enable a flexible and adjustable termination of the broadcast serial bus. In particular, the subsea node may be a terminating node which terminates the broadcast serial bus. It may achieve similar advantageous as the ones outlined further above.

In an embodiment, the subsea node is adapted to automatically determine the number of further nodes connected to the broadcast serial bus. It may further be configured to adjust the adjustable impedance by means of the adjusting unit in accordance with the determined number of connected nodes. Thus an automatic compensation of the total bus impedance for missing or disconnected nodes can be achieved. The subsea node may for example be a master node located in a subsea canister. The remaining nodes may be sensor nodes external to the subsea canister. In case of failure of one of these external nodes, the node maybe disconnected, which can be compensated by the subsea node. The external nodes may certainly also be provided in a subsea canister, e.g. of the equipment which makes use of them, or in their own canister.

In an embodiment, the subsea node and the further nodes connected to the broadcast serial bus are fed with power from the same power bus. The subsea node is adapted to measure the power consumption on the power bus in order to determine the number of further nodes connected to the broadcast serial bus. As an example, if nodes are disconnected, the power consumption will be reduced, which can be used by the subsea node to determine the reduced number of nodes connected to the broadcast serial bus. The nodes connected to the broadcast serial bus may for example be of the same type (e.g. sensor nodes) and may thus consume the same amount of electric power. The current on the power bus may then be measured by the subsea node in order to determine the power consumption and thus the number of connected nodes. If the number of connected nodes was determined, the subsea node may automatically set the adjustable impedance to a resistance value which ensures that the total bus impedance of the broadcast serial bus matches the predetermined bus impedance.

According to the invention, a subsea broadcast serial bus system is provided. The subsea broadcast serial bus system comprises a broadcast serial bus having a first signal line and a second signal line, one or more nodes connected in parallel to the first signal line and the second signal line of the broadcast serial bus, wherein each node connects the first signal line to the second signal line via a node impedance, and a subsea node in any of the configurations mentioned above, which is connected to the first signal line and the second signal line and terminates the broadcast serial bus.

Such subsea broadcast serial bus system is flexible with respect to the connection and disconnection of nodes. Furthermore, it may achieve any of the advantages outlined further above.

According to the invention, the subsea broadcast serial bus system further comprises a subsea canister. The subsea node is a master node located inside the subsea canister. The further nodes are located outside the subsea canister.

The further nodes connected to the broadcast serial bus may sensor nodes located outside the subsea canister. In such configuration, further nodes may be connected to or may be removed from the broadcast serial bus, e.g. when installing new equipment or removing equipment from a subsea installation. The subsea canister comprising the master node may thus not need to be removed for adjusting the broadcast serial bus termination, as the adjustable impedance may be remotely set or may be automatically set.

In a further embodiment, the subsea broadcast serial bus system further comprises a power bus, wherein the subsea node and the further nodes connected to the broadcast serial bus are supplied with electric power by the power bus. Besides having a common electric reference, the subsea node may thus be enabled to automatically determine the number of nodes connected to the power bus, e.g. as mentioned above by measuring a current on the power bus. In the configuration in which the system comprises a subsea canister in which the subsea node is located, the power bus may be supplied with electric power inside the subsea canister. The power bus may for example be coupled inside the canister to a power supply network, or to a transformer or the like.

The broadcast serial bus may be a serial based multidrop bus, and it may in particular be a controller area network (CAN) bus or a Profibus.

A further embodiment provides a method for terminating a broadcast serial bus, the method comprising the steps of determining a number of nodes connected to the broadcast serial bus, adjusting an impedance of a node connected between a first signal line and a second signal line of the broadcast serial bus in accordance with the determined number of connected nodes, wherein the step of adjusting the impedance is performed such that the total impedance on the broadcast serial bus corresponds to a predetermined bus impedance at which the broadcast serial bus is to be operated.

With this method, advantages similar to the ones outlined further above may be achieved.

In embodiments, the method may make use of any of the features mentioned further above. The impedance may be adjusted automatically or by user input. It may for example be performed by an adjusting unit, which may be implemented as outlined above. The method may be performed by the above mentioned broadcast serial bus termination circuit, subsea node or subsea broadcast serial bus system.

The features of the embodiments of the invention mentioned above and those yet to be explained below can be combined with each other unless noted to the contrary.

BRIEF DESCRIPTION OF THE DRAWINGS

The forgoing and other features and advantages of the invention will become further apparent from the following detailed description read in conjunction with the accompanying drawings. In the drawings, like reference numerals refer to like elements.

Figure 1    illustrates a prior art CAN bus.
Figure 2    is a schematic diagram illustrating a subsea broadcast serial bus system comprising a subsea node in accordance with an embodiment of the invention.
Figure 3    is a schematic diagram illustrating the implementation of an adjustable impedance in accordance with an embodiment of the invention.

Figure 4    is a schematic diagram illustrating the implementation of an adjustable impedance in accordance with a further embodiment of the invention.

Figure 5    is a schematic diagram illustrating a subsea node in accordance with an embodiment of the invention.

Figure 6    is a schematic flow diagram illustrating a method of adjusting the termination impedance of a broadcast serial bus according to an embodiment of the invention.

DETAILED DESCRIPTION

In the following, embodiments of the invention will be described in detail with reference to the accompanying drawings. It is to be understood that the following description of the embodiments is given only for the purpose of illustration and is not to be taken in a limiting sense.

It should be know that the drawings are to be regarded as being schematic representations only, and that elements in the drawings are not necessarily to scale with each other. Rather, the representation of the various elements is chosen such that their function and general purpose becomes apparent to a person skilled in the art. The skilled person will appreciate that the physical or functional units illustrated and described herein with respect to the different embodiments do not necessarily need to be implemented as physically separate units. One or more physical or functional blocks or units may be implemented in a common circuit, chip, circuit element or unit, while other physical or functional blocks or units may be implemented in separate circuits, chips, circuit elements or units.

It should be understood that while the following description may be given with reference to a controller area network (CAN) bus and may refer to sensor nodes connected thereto, the teachings of the disclosure are similarly applicable to other types of broadcast serial busses and other types of nodes connected thereto.

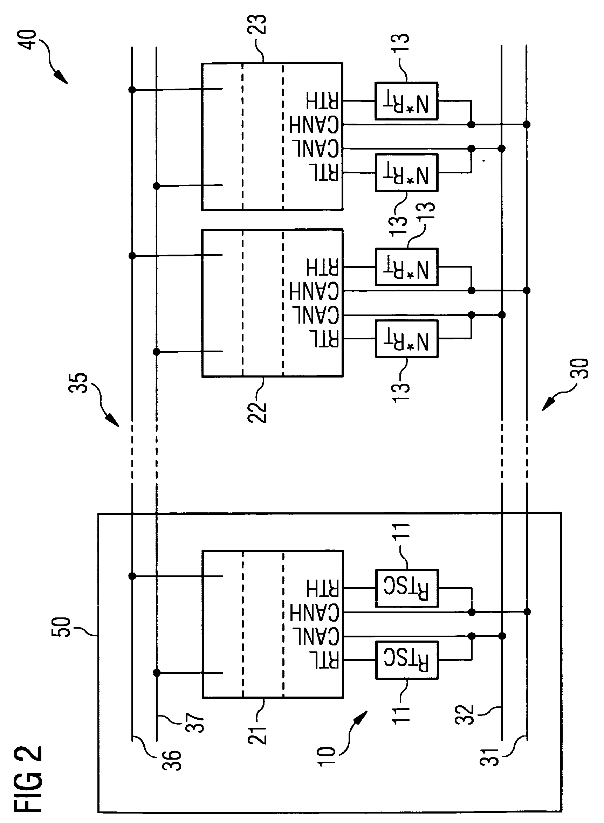

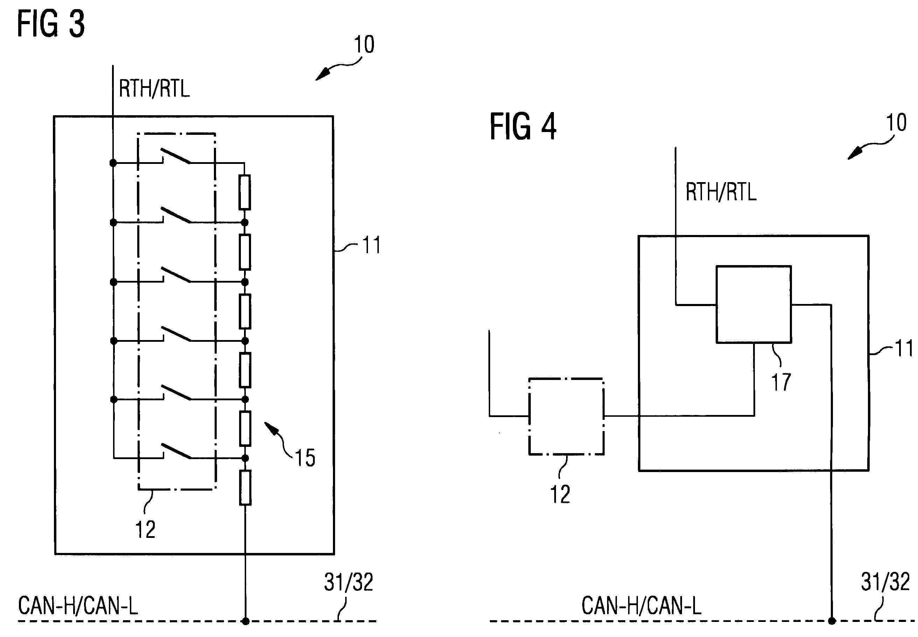

Figure 2 schematically illustrates a broadcast serial bus termination circuit 10 which is coupled to a broadcast serial bus 30, a CAN bus in the present example. The broadcast serial bus 30 has a first signal line 31 (CANH) and a second signal line 32 (CANL). The broadcast serial bus termination circuit 10 comprises an adjustable impedance 11, which is connected between the first a second signal lines 31, 32 of the broadcast serial bus 30 in operation. The broadcast serial bus termination circuit further comprises an adjusting unit, which is not explicitly shown in figure 2, but will be explained later with respect to figures 3 and 4.

Figure 2 further illustrates a subsea node 21 according to an embodiment of the invention, which comprises the broadcast serial bus termination circuit 10. Subsea node 21 may be a master node, e.g. a node having a high priority, in particular the highest priority of the nodes connected to bus 30. Subsea node 21 is coupled to the lines 36 and 37 of the power bus 35, from which it obtains the supply voltage required for operation.

Figure 2 further illustrates a subsea broadcast serial bus system 40 which comprises the subsea node 21, the broadcast serial bus 30, the power bus 35 and further nodes 22, 23, ... connected to the two busses 30, 35. This system may be part of a subsea based sensor network. Subsea node 21 can be a master node located in a subsea canister 50, wherein the remaining nodes 22, 23, ... are external nodes, for example subsea sensor nodes. The power to each sensor node 22, 23, ... is supplied from the subsea canister 50 on the power bus 35. The nodes are connected in parallel to the broadcast serial bus 30, meaning that each node connects the two signal lines 31, 32, and that the removal of a node from bus 30 does not interrupt the connection between the remaining connected nodes.

A node 21, 22, 23 coupled to the broadcast serial bus 30 may have a configuration that may be described as three levels. On an application level, a microcontroller may communicate with a sensor or other equipment such a controller, an actuator or the like. The microcontroller can transmit commands or data to the equipment or may receive data or commands from the equipment, which are to be transported on the broadcast serial bus. The micro processor may hand down the user data that is to be send to a next level, which comprises a bus controller, e.g. a CAN controller. The bus controller may for example compile a frame or a message in accordance with to the protocol used for data transmission on the broadcast serial bus 30, it may further provide a check sum and may initiate the sending of the frame/message. It may further decode received messages and provide the user data extracted from the received message to the microcontroller.

On the lowest level, a transceiver may perform the actual physical generation of signals to be transmitted on signal lines 31, 32 of the broadcast serial bus 30.

The transceiver may comprise a driver which generates the CAN_H and CAN_L signals on the signal lines of the bus 30. It may further comprise a receiver, e.g. in form of a comparator, which reads voltage signals of the signal lines.

To achieve high noise immunity, the broadcast serial bus 30 is maintained at a low differential bus impedance. This may be achieved by using a low value terminating resistance, which may have a value in a range of about 50 - 1000 Ohms, e.g. 100 or 120 Ohms. A dominant state may be set on the bus by the transceiver applying +5 volt to CAN_H and zero volt to CAN_L. A recessive state may be present on the bus if non of the transceivers of the nodes connected to the bus is asserting a dominant state. Both signal lines may then be at a potential of about 2.5 V, e.g. 2.6 V and 2.4 V for the CANH and CANL signal lines, respectively.

Note that the above values in the description of the operation of the bus system are only given for the purpose of illustration and are not to be taken in a limiting sense.

Each node has a node impedance 13 in form of e.g. a termination resistance which is connected across the bus lines 31, 32 when the node is connected thereto. To achieve a total bus impedance of $R_T$, the value of the termination resistance 13 in each node connected to the bus 30 can be set to $N \cdot R_T$, wherein N is the total number of the nodes connected to a bus (including the master node 21 located in the subsea canister). N-1 external sensor nodes 22, 23, ... can then be connected to the bus 30. If fewer than N-1 external nodes are connected, the total bus impedance is raised, which may result in a degraded operation of broadcast serial bus 30, in particular in a loss of signal quality, increased signal reflections and there like.

To enable a more flexible connection of nodes to the broadcast serial bus 30 without degrading the quality of signal transmission on the bus, e.g. to enable the connection of a variable number of external nodes to the bus 30, the subsea node 21 comprises the termination circuit 10 in which an adjustable impedance 11 ($R_{TSC}$) is used. Adjustable impedance 11 may be implemented by a termination resistor having an adjustable resistance value. It is in particular adjustable in dependence on the number of connected external nodes 22, 23, .... In order to adjust the total impedance of broadcast serial bus 30 to the desired bus impedance, the resistance value of the adjustable impedance 11 can be determined as follows. The total impedance $R_T$ on the broadcast serial bus 30 can be calculated as:

$$R_T = \frac{\left(\dfrac{N * R_T}{n}\right) * R_{TSC}}{\left(\dfrac{N * R_T}{n}\right) + R_{TSC}} \qquad (1)$$

wherein N is the maximum total number of nodes connected to broadcast serial bus 30 (including subsea node 21), n is the number of currently connected external nodes, and $R_{TSC}$ is the resistance value of the adjustable impedance of subsea node 21 in subsea canister 50. As mentioned above, $R_{TSC}$ should be set so that the desired bus impedance $R_T$ is reached, e.g. $R_T$ = 100 Ohm or 120 Ohm.

Solving this equation, $R_{TSC}$ can be determined to

$$R_{TSC} = \frac{N * R_T}{N - n} \qquad (2)$$

for any number of connected external (sensor) nodes between 1 and N-1.

To reach the desired total bus impedance $R_T$, the adjustable impedance can be implemented with selectable resistance values $R_{TSC}$ for n = 1 to n = N-1, and the selection of the resistance value $R_{TSC}$ can be done with respect to the currently connected number of nodes n. In such set up, the total impedance of broadcast serial bus 30 can be adjusted to have the desired value of $R_T$.

As an example, if the maximum number of nodes (N) is connected to broadcast serial bus 30, the adjustable impedance 11 will have resistance value of $R_{TSC}$ = N * $R_T$, similar to all remaining nodes connected to bus 30. If nodes are now remove from the bus, the number n of external nodes connected to the bus decreases. According to equation 2, if one, two or three nodes are removed from broadcast serial bus 30, the resistance $R_{TSC}$ can be determined to N * $R_T$/2, N * $R_T$/3 and N * $R_T$/4, respectively. As can be seen, the resistance value is an integer fraction of the node impedance N * $R_T$, wherein the denominator corresponds to the number of removed external nodes + 1.

In this respect it should be noted that when configuring the subsea broadcast serial bus system 40, N may be set to a number higher than the number of external nodes that are actually supposed to be installed, so that the possibility to install further external nodes exists.

As can be seen, by making use of the broadcast serial bus termination circuit including the adjustable impedance 11, the total impedance on broadcast serial bus 30 can be maintained constant even when external nodes 22, 23, ... are disconnected from bus 30 or when additional nodes are connected to the bus.

It should be clear that subsea node 21 and subsea broadcast serial bus system 40 which is schematically illustrated in figure 2 may comprise further components, or may be provided in different configurations. As an example, subsea node 21 may be provided with a body in which the adjustable resistances 11 are incorporated, and which may be provided with connectors for connecting to the broadcast serial bus 30. Further impedances, in particular resistors, can be provided, they may for example be switched parallel or in series with adjustable impedance 11.

Note that each node comprises two termination impedances. One impedance may for example be connected between the high signal line (CAN_H) and the ground rail (0V) and the other between the low signal line (CAN_L) and the high voltage rail (e.g. +5V) in operation. Note that this is just one possible configuration of the nodes 21, 22, 23, ..., and that other configurations are also conceivable. Although illustrates as separate units for reasons of comprehensiveness, it should be clear that adjustable impedance 11 is part of subsea node 21, and that the node impedances 13 are part of the respective node 22, 23, .... The detailed and general explanations given above also apply to the further examples described herein below.

Figures 3 and 4 illustrate schematically different configurations of the broadcast serial bus termination circuit 10 which may be implemented in the subsea node 21 of figure 2. In figure 3, the adjustable impedance 11 of the broadcast serial bus termination circuit 10 comprises a resistor ladder 15. The adjustable impedance 11 can be the terminating resistor for the high (H) or the low (L) signal line, and as indicated, it may thus be connected to either CAN_H or CAN_L. The adjustable impedance 11 comprises an adjusting unit 12, which in the present example is implemented as a number of switches using which the resistance value of the adjustable impedance 11 can be selected.

The switches of the adjusting unit 12 may be mechanical switches or electronic switches. The resistors in the resistor ladder 15 can be configured such that by closing the switches of adjusting unit 12, the total resistance of the adjustable impedance 11 can be set in the above mentioned steps, e.g. to integer fractions of $N * R_T$. The resistors of the resistor ladder 15 may for example be configured to give a maximum resistance of $NR_T$, which can be set by closing the top switch.

The switches of adjusting unit 12 may be mechanical switchers, such as dip switches. In other configurations, they may be electronic switches. A micro controller may be provided in the subsea node, which controls the electronic switches. The micro controller may receive a command, e.g. over a communication connection, to set the appropriate resistance, or a software running on the micro controller may set the resistance. The resistance value of the adjustable impedance 11 may thus be set by controlling the software or by sending a command from the remote location.

In the example of figure 4, the adjustable impedance 11 comprises a voltage controlled resistance 17, which can be implemented as a field effect transistor (FET) in particular a junction gate field effect transistor (JFET). By providing a corresponding control voltage at the gate of the voltage controlled resistance 17, the resistance value of the adjustable impedance 11 can be set. For this purpose, adjusting unit 12 may be provided, which may comprise a controller, such as a micro processor, digital signal processor or the like. The adjusting unit 12 provides the control voltage to the voltage controlled resistance 17, thereby adjusting the resistance value of the adjustable impedance 11 in the above outlined manner, e.g. in integer fraction of the node impedance $NR_T$. The controller or adjusting unit 12 may again use a preconfigured software to select the appropriate control voltage, or may receive a command from a remote location, which is for example input by a user, to just the control voltage.

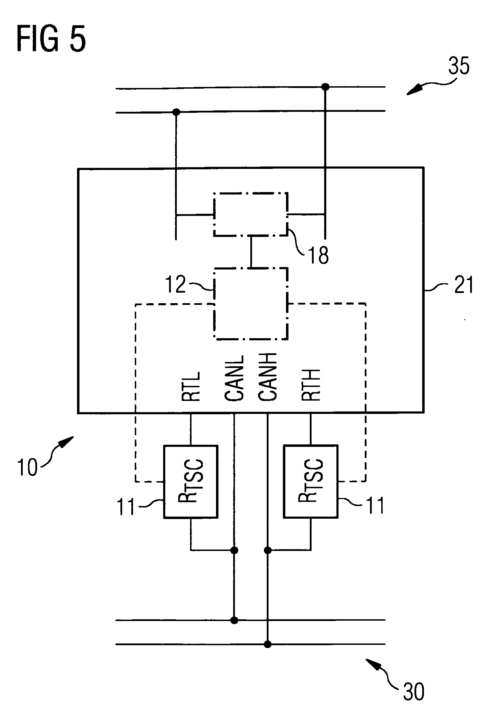

In other configurations, the adjusting unit 12 may adjust the resistance value automatically, as will be explained with respect to figure 5. Figure 5 illustrates a possible implementation of subsea node 21 in more detail, wherein the subsea node 21 can comprise a broadcast serial bus termination circuit 10 having a configuration as outlined with respect to figure 2, figure 3 or figure 4. Subsea node 21 is connected to the power bus 35 and the broadcast serial bus 30. The termination circuit 10 again comprises the adjustable impedances 11 and the adjusting unit 12, which is implemented as a controller adapted to automatically set the resistance value of each adjustable impedance 11. Adjustable impedance 11 can be a resistor ladder network having electronic switches, a voltage controled resistance or there like. Adjusting unit 12 interfaces each adjustable impedance 11 to provide a corresponding control signal. Subsea node 21 further comprises a measuring unit 18. Measuring unit 18 interfaces the adjusting unit 12. By means of the measuring unit 18 the adjusting unit 12 determines the number of external nodes connected to the broadcast serial bus 30 and in accordance with the determined number, automatically sets the resistance value of the adjustable impedance 11.

Each external node is supplied with power from the subsea canister 50 by the power bus 35. Using measuring unit 18, the power consumption of all connected nodes is measured by measuring the power consumption on the power bus 35. This is particularly simple if all nodes connected to the power bus 35 are of the same type and thus have the same power consumption. Each node will then add the same current to the total current on the power bus 35. If each sensor uses a current I, than the total current on the power bus 35 will be $m * I$, with m being the total number of currently connected nodes (including node 21). The number of externally connected nodes n can thus be determined automatically, and the resistance value $R_{TSC}$ of the adjustable impedance 11 can be set accordingly.

Measuring unit 18 may thus be configured so as to measure the current on power bus 35. Adjusting unit 12 may be preconfigured with the information on which current a single node requires, and may accordingly determined the number of connected nodes from the total current. It can set $R_{TSC}$ to the appropriate value, e.g. as outlined above with respect to equation 2.

The full automatic adjustment of $R_{TSC}$ thus becomes possible. Thereby, an automatic and dynamic termination of the broadcast serial bus 30 can be realized, which results in the desired total bus impedance irrespective of the number of connected external nodes in a range of n = 1 to n = N - 1.

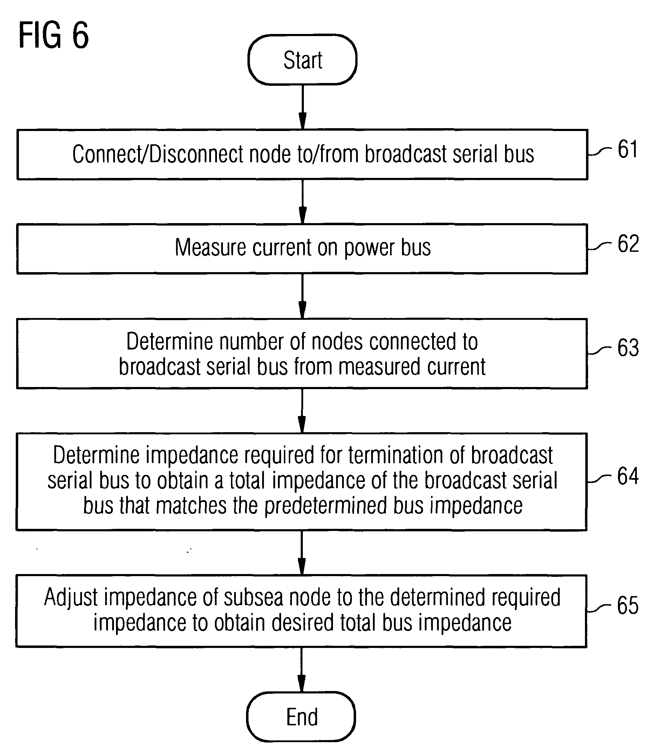

Figure 6 is a flow diagram of a method according to an embodiment of the invention. The method may be performed by means of a broadcast serial bus termination circuit, subsea node and subsea broadcast serial bus system in any of the configurations outlined above. In step 61, a node, in particular a sensor node is connected to or disconnected from the broadcast serial bus, in particular a serial based multidropped bus. The current on the power bus 35 is measured in step 62. Based on the current measurement, the number of nodes connected to the broadcast serial bus is determined in step 63. In step 64 it is determined which termination impedance is required from subsea node 21 so that the total impedance of the broadcast serial bus matches the predetermined bus impedance. This determination can be based on the number of connected nodes and equation 2.

The adjustable impedance of the subsea node is then adjusted in step 65 to the determined required impedance in order to obtain the desired total bus impedance. This again may be achieved by providing a corresponding control signal to electronic switches of a resistor ladder or by providing a control voltage to a voltage controlled resistor.

Step 62 may be performed by measuring unit 18, while steps 63 to 65 may be performed by the adjusting unit 12, which can be implemented as a controller using a micro processor, a digital signal processor, an ASIC, an FPGA or the like.

With the above embodiments, a dynamic and adjustable termination of the broadcast serial bus becomes possible. The broadcast serial bus may in particular be a controller area network (CAN) bus, a Profibus or any other type of serial based multidrop bus. In particular it becomes possible to upgrade the number of nodes, in particular sensors, connected to an existing bus or network during its life cycle, while the desired total impedance on the broadcast serial bus can be achieved irrespective of the number of connected nodes. The maximum number of connecting nodes N for which the subsea node/the termination circuit can adjust the impedance of the broadcast serial bus can be selected before installation. By setting N to a higher number, it is possible to connect further nodes to the bus at a later stage, so that a future expansion of the bus system, in particular a sensor network, is possible without the need to service the master node/bus termination.

**Claims**

1. A subsea broadcast serial bus system, comprising:

   - a broadcast serial bus (30) having a first signal line (31) and a second signal line (32), wherein the broadcast serial bus (30) is to be operated with a predetermined bus impedance ($R_T$);
   - one or more nodes (22, 23) connected in parallel to the first signal line (31) and the second signal line (32) of the broadcast serial bus (30), each node (22, 23) connecting the first signal line to the second signal line via a node impedance (13);
   - a subsea node (21) connected to the first signal line (31) and the second signal line (32) and terminating the broadcast serial bus (30); and
   - a subsea canister (50), wherein the subsea node (21) is a master node located inside the subsea canister (50), and wherein the one or more nodes (22, 23) are located outside the subsea canister (50);

   wherein the subsea node (21) comprises a broadcast serial bus termination circuit (10) that is, in operation, connected to the first and second signal lines (31; 32), wherein the broadcast serial bus termination circuit (10) comprises:

   - an adjustable impedance (11) that is, in operation, connected between the first signal line (31) and the second signal line (32) of the broadcast serial bus (30); and
   - an adjusting unit (12) adapted to adjust the adjustable impedance (11), the adjusting unit (12) being configured to enable an adjustment of the adjustable impedance in dependence on the number (n) of nodes (22, 23) connected to the broadcast serial bus and to be capable of adjusting the adjustable impedance (11) such that for different numbers (n) of nodes connected to the broadcast serial bus (30), the total impedance of the broadcast serial bus (30) corresponds to the predetermined bus impedance ($R_T$).

2. The subsea broadcast serial bus system according to claim 1, wherein the adjustable impedance (11) is adapted to be adjustable to integer fractions of the node impedance (13).

3. The subsea broadcast serial bus system according to claim 1 or 2, wherein the adjustable impedance (11) comprises a voltage controlled resistance (17).

4. The subsea broadcast serial bus system according to any of the preceding claims, wherein the adjustable impedance (11) comprises a field effect transistor, in particular a JFET.

5. The subsea broadcast serial bus system according to claim 1 or 2, wherein the adjustable impedance (11) comprises a resistor ladder (15).

6. The subsea broadcast serial bus system according to any of the preceding claims, wherein the adjusting unit (12) comprises a controller adapted to control the value of the adjustable impedance (11).

7. The subsea broadcast serial bus system according to any of the preceding claims, wherein the adjusting unit (12) comprises mechanical switches configured such that by actuation of the mechanical switches, different values of the adjustable impedance (11) are selectable.

8. The subsea broadcast serial bus system according to any of the preceding claims, wherein the broadcast serial bus termination circuit (10) is configured to be capable of adjusting the total impedance of the broadcast serial bus (30) to match the predetermined bus impedance ($R_T$) for any number of nodes (22, 23) connected to the broadcast serial bus (30) up to a predetermined maximum number (N) of nodes.

9. The subsea broadcast serial bus system according to any of the preceding claims, wherein the subsea node (21) is adapted to automatically determine the number (n) of further nodes (22, 23) connected to the broadcast serial bus and, by means of the adjusting unit (12), to adjust the adjustable impedance (11) in accordance with the determined number of connected nodes.

10. The subsea broadcast serial bus system according to any of the preceding claims, wherein the subsea node (21) and the further nodes (22, 23) connected to the broadcast serial bus are fed with power from the same power bus (35), and wherein the subsea node is adapted to measure the power consumption on the power bus (35) in order to determine the number (n) of further nodes connected to the broadcast serial bus.

11. The subsea broadcast serial bus system according to any of the preceding claims, wherein the subsea broadcast serial bus system comprises one or more further subsea canisters housing one or more of said further nodes (22, 23).

12. The subsea broadcast serial bus system according to any of the preceding claims, wherein the further nodes (22, 23) connected to the broadcast serial bus (30) are sensor nodes.

13. The subsea broadcast serial bus system according to any of the preceding claims, further comprising a power bus (35), wherein the subsea node and the further nodes connected to the broadcast serial bus (30) are supplied with electric power by the power bus (35).

14. A method of terminating a broadcast serial bus (30) of a subsea broadcast serial bus system comprising a broadcast serial bus (30) having a first signal line (31) and a second signal line (32), one or more nodes (22, 23) connected in parallel to the first signal line (31) and the second signal line (32) of the broadcast serial bus (30), each node (22, 23) connecting the first signal line to the second signal line via a node impedance (13), a subsea node (21) connected to the first signal line (31) and the second signal line (32) and terminating the broadcast serial bus (30), wherein the subsea node (21) is a master node located inside a subsea canister (50), and wherein the one or more nodes (22, 23) are located outside the subsea canister (50), the method comprising the steps of:

- determining a number (n) of nodes (22, 23) connected to the broadcast serial bus (30) and located outside the subsea canister (50);
- adjusting an impedance (11) of the subsea node (21) located inside the subsea canister (50) in accordance with the determined number of connected nodes (22, 23),

wherein the step of adjusting the impedance (11) is performed such that the total impedance on the broadcast serial bus (30) corresponds to a predetermined bus impedance ($R_T$) at which the broadcast serial bus is to be operated.

**Patentansprüche**

1. Unterwasser-Broadcast-Serienanschlusssystem bestehend aus:

- einem Broadcast-Serienanschluss (30) mit einer ersten Signalleitung (31) und einer zweiten Signalleitung (32), wobei der Broadcast-Serienanschluss (30) mit einer vorgegebenen Serienanschlussimpedanz ($R_T$) betrieben wird;
- einem oder mehreren Knoten (22, 23), die parallel an die erste Signalleitung (31) und die zweite Signalleitung (32) des Broadcast-Serienanschlusses (30) angeschlossen sind, wobei jeder Knoten (22, 23) die erste Signalleitung über eine Knotenimpedanz (13) mit der zweiten Signalleitung verbindet;
- einem Unterwasserknoten (21), der mit der ersten Signalleitung (31) und mit der zweiten Signalleitung (32) verbunden ist und den Broadcast-Serienanschluss (30) abschießt und
- einem Unterwasserbehälter (50), wobei der Unterwasserknoten (21) ein Masterknoten im Inneren des Unterwasserbehälters (50) ist und wobei der eine oder die mehreren Knoten (22, 23) sich außerhalb des Unterwasserbehälters befinden;

wobei der Unterwasserknoten (21) eine Abschlussschaltung (10) des Broadcast-Serienanschlusses umfasst, die in Betrieb mit der ersten und der zweiten Signalleitung (31, 32) verbunden ist, wobei die Abschlussschaltung (10) des Broadcast-Serienanschlusses umfasst:

- eine regelbare Impedanz (11), die in Betrieb zwischen der ersten Signalleitung (31) und der zweiten Signalleitung (32) des Broadcast-Serienanschlusses (30) angeschlossen ist und
- eine Reguliereinheit (12), die dafür eingerichtet ist, die regelbare Impedanz (11) einzustellen, wobei die Reguliereinheit (12) dafür eingerichtet ist, die Regulierung der regelbaren Impedanz (11) in Abhängigkeit von der Anzahl (n) der an den Broadcast-Serienanschluss (30) angeschossenen Knoten (22, 23) zu ermöglichen und die regelbare Impedanz (11) so regeln zu können, dass die Gesamtimpedanz des Broadcast-Serienanschlusses (30) für die unterschiedlichen Anzahlen (n) der an den Broadcast-Serienanschluss (30) angeschlossenen Konten der vorgegebenen Serienanschlussimpedanz ($R_T$) entspricht.

2. Unterwasser-Broadcast-Serienanschlusssystem nach Anspruch 1, wobei die regelbare Impedanz (11) dafür eingerichtet ist, auf ganzzahlige Teile der Knotenimpedanz (13) einstellbar zu sein.

3. Unterwasser-Broadcast-Serienanschlusssystem nach Anspruch 1 oder 2, wobei die regelbare Impedanz (11) einen spannungsgesteuerten Widerstand (17) umfasst.

4. Unterwasser-Broadcast-Serienanschlusssystem nach einem der vorhergehenden Ansprüche, wobei die regelbare Impedanz (11) einen Feldeffekttransistor umfasst, insbesondere einen Sperrschicht-Feldeffekttransistor.

5. Unterwasser-Broadcast-Serienanschlusssystem nach Anspruch 1 oder 2, wobei die regelbare Impedanz (11) eine Widerstandsleiter (15) umfasst.

6. Unterwasser-Broadcast-Serienanschlusssystem nach einem der vorhergehenden Ansprüche, wobei die Reguliereinheit (12) einen Regler umfasst, der dafür eingerichtet ist, den Wert der regelbaren Impedanz (11) zu steuern.

7. Unterwasser-Broadcast-Serienanschlusssystem nach einem der vorhergehenden Ansprüche, wobei die Reguliereinheit (12) mechanische Schalter umfasst, die dafür eingerichtet sind, dass durch Betätigen der mechanischen Schalter unterschiedliche Werte der regelbaren Impedanz (11) ausgewählt werden können.

8. Unterwasser-Broadcast-Serienanschlusssystem nach einem der vorhergehenden Ansprüche, wobei die Abschlussschaltung (10) des Broadcast-Serienanschlusses dazu eingerichtet ist, die Gesamtimpedanz des Broadcast-Serienanschlusses (30) gemäß der vorgegebenen Serienanschlussimpedanz ($R_T$) für eine beliebige Anzahl von an den Broadcast-Serienanschluss (30) angeschlossene Knoten (22, 23) bis zur vorgegebenen Maximalzahl (N) von Knoten anzupassen.

9. Unterwasser-Broadcast-Serienanschlusssystem nach einem der vorhergehenden Ansprüche, wobei der Unterwasserknoten (21) dafür eingerichtet ist, automatisch die Anzahl (n) weiterer an den Broadcast-Serienanschluss angeschlossener Knoten (22, 23) zu ermitteln und die regelbare Impedanz (11) mit Hilfe der Reguliereinheit (12) gemäß der ermittelten Anzahl angeschlossener Knoten einzustellen.

10. Unterwasser-Broadcast-Serienanschlusssystem nach einem der vorhergehenden Ansprüche, wobei der Unterwasserknoten (21) und die weiteren an den Broadcast-Serienanschluss angeschlossenen Knoten (22, 23) vom selben Spannungsverteiler (35) mit elektrischem Strom versorgt werden und wobei der Unterwasserknoten dafür eingerichtet ist, den Stromverbrauch am Spannungsverteiler (35) zu messen, um die Anzahl (n) weiterer an den Broadcast-Serienanschluss angeschlossener Knoten zu ermitteln.

11. Unterwasser-Broadcast-Serienanschlusssystem nach einem der vorhergehenden Ansprüche, wobei das Unterwasser-Broadcast-Serienanschlusssystem einen oder mehrere weitere Unterwasserbehälter umfasst, die einen oder mehrere der weiteren Knoten (22, 23) aufnehmen.

12. Unterwasser-Broadcast-Serienanschlusssystem nach einem der vorhergehenden Ansprüche, wobei es sich bei den weiteren an den Broadcast-Serienanschluss (30) angeschlossenen Knoten (22, 23) um Sensorknoten handelt.

13. Unterwasser-Broadcast-Serienanschlusssystem nach einem der vorhergehenden Ansprüche, das ferner einen Spannungsverteiler (35) umfasst, wobei der Unterwasserknoten und die weiteren an den Broadcast-Serienanschluss (30) angeschlossenen Knoten vom Spannungsverteiler (35) mit elektrischem Strom versorgt werden.

14. Verfahren zum Abschließen eines Broadcast-Serienanschlusses (30) eines Unterwasser-Broadcast-Serienanschlusssystems bestehend aus einem Broadcast-Serienanschluss (30) mit einer ersten Signalleitung (31) und einer zweiten Signalleitung (32), einem oder mehreren Knoten (22, 23), die parallel an die erste Signalleitung (31) und an die zweite Signalleitung (32) des Broadcast-Serienanschlusses (30) angeschlossen sind, wobei jeder Knoten (22, 23) die erste Signalleitung mit der zweiten Signalleitung über eine Knotenimpedanz (13) verbindet, einem Unterwasserknoten (21), der an die erste Signalleitung (31) und an die zweite Signalleitung (32) angeschlossen ist und den Broadcast-Serienanschluss (30) abschließt, wobei der Unterwasserknoten (21) ein Masterknoten ist, der sich im Inneren eines Unterwasserbehälters (50) befindet, und wobei der eine oder die mehreren Knoten (22, 23) sich außerhalb des Unterwasserbehälters (50) befinden, wobei das Verfahren die folgenden Schritte umfasst:

- Bestimmen der Anzahl (n) der Knoten (22, 23), die an den Broadcast-Serienanschluss (30) angeschlossen sind und sich außerhalb des Unterwasserbehälters (50) befinden;
- Einstellen einer Impedanz (11) des Unterwasserknotens (21), der sich im Inneren des Unterwasserbehälters (50) befindet, gemäß der ermittelten Anzahl angeschlossener Knoten (22, 23),

wobei der Schritt des Einstellens der Impedanz (11) so ausgeführt wird, dass die Gesamtimpedanz für den Broadcast-Serienanschluss (30) einer vorgegebenen Serienanschlussimpedanz ($R_T$) entspricht, bei der der Broadcast-Serienanschluss betrieben werden soll.

**Revendications**

1. Un système de bus série de diffusion sous-marin, comprenant :

- un bus série de diffusion (30) possédant une première ligne de signal (31) et une deuxième ligne de signal (32), le bus série de diffusion (30) étant destiné à être actionné avec une impédance de bus prédéterminée ($R_T$),
- un ou plusieurs noeuds (22, 23) raccordés en parallèle à la première ligne de signal (31) et à la deuxième ligne de signal (32) du bus série de diffusion (30), chaque noeud (22, 23) raccordant la première ligne de signal à la deuxième ligne de signal par l'intermédiaire d'une impédance de noeud (13),
- un noeud sous-marin (21) raccordé à la première ligne de signal (31) et à la deuxième ligne de signal (32) et terminant le bus série de diffusion (30), et
- un récipient sous-marin (50), le noeud sous-marin (21) étant un noeud maître placé à l'intérieur du récipient sous-marin (50) et les un ou plusieurs noeuds (22, 23) étant placés à l'extérieur du récipient sous-marin (50),

dans lequel le noeud sous-marin (21) comprend un circuit de terminaison de bus série de diffusion (10) qui, en fonctionnement, est raccordé aux première et deuxième lignes de signal (31, 32), le circuit de terminaison de bus série de diffusion (10) comprenant :

- une impédance ajustable (11) qui, en fonctionnement, est raccordée entre la première ligne de signal (31) et la deuxième ligne de signal (32) du bus série de diffusion (30), et
- une unité d'ajustement (12) adaptée de façon à ajuster l'impédance ajustable (11), l'unité d'ajustement (12) étant configurée de façon à permettre un ajustement de l'impédance ajustable en fonction du nombre (n) de noeuds (22, 23) raccordés au bus série de diffusion et de façon à être capable d'ajuster l'impédance ajustable (11) de sorte que, pour des nombres (n) différents de noeuds raccordés au bus série de diffusion (30), l'impédance totale du bus série de diffusion (30) correspond à l'impédance de bus prédéterminée ($R_T$).

2. Le système de bus série de diffusion sous-marin selon la revendication 1, dans lequel l'impédance ajustable (11) est adaptée de façon à être ajustable à des fractions de nombre entier de l'impédance de noeud (13).

3. Le système de bus série de diffusion sous-marin selon la revendication 1 ou 2, dans lequel l'impédance ajustable (11) comprend une résistance commandée par tension (17).

4. Le système de bus série de diffusion sous-marin selon l'une quelconque des revendications précédentes, dans lequel l'impédance ajustable (11) comprend un transistor à effet de champ, plus particulièrement un JFET.

5. Le système de bus série de diffusion sous-marin selon la revendication 1 ou 2, dans lequel l'impédance ajustable (11) comprend une échelle de résistance (15).

6. Le système de bus série de diffusion sous-marin selon l'une quelconque des revendications précédentes, dans lequel l'unité d'ajustement (12) comprend un dispositif de commande adapté de façon à commander la valeur de l'impédance ajustable (11).

7. Le système de bus série de diffusion sous-marin selon l'une quelconque des revendications précédentes, dans lequel l'unité d'ajustement (12) comprend des commutateurs mécaniques configurés de sorte que, par un actionnement des commutateurs mécaniques, différentes valeurs de l'impédance ajustable (11) soient sélectionnables.

8. Le système de bus série de diffusion sous-marin selon l'une quelconque des revendications précédentes, dans lequel le circuit de terminaison de bus série de diffusion (10) est configuré de façon à être capable d'ajuster l'impédance totale du bus série de diffusion (30) de façon à correspondre à l'impédance de bus prédéterminée (RT) pour tout nombre de noeuds (22, 23) raccordés au bus série de diffusion (30) jusqu'à un nombre maximum prédéterminé (N) de noeuds.

9. Le système de bus série de diffusion sous-marin selon l'une quelconque des revendications précédentes, dans lequel le noeud sous-marin (21) est adapté de façon à déterminer automatiquement le nombre (n) d'autres noeuds (22, 23) raccordés au bus série de diffusion et, au moyen de l'unité d'ajustement (12), à ajuster l'impédance ajustable (11) conformément au nombre déterminé de noeuds raccordés.

10. Le système de bus série de diffusion sous-marin selon l'une quelconque des revendications précédentes, dans lequel le noeud sous-marin (21) et les autres noeuds (22, 23) raccordés au bus série de diffusion sont alimentés avec une alimentation électrique provenant du même bus d'alimentation électrique (35), et dans lequel le noeud sous-marin est adapté de façon à mesurer la consommation électrique sur le bus d'alimentation électrique (35) de façon à déterminer le nombre (n) d'autres noeuds raccordés au bus série de diffusion.

11. Le système de bus série de diffusion sous-marin selon l'une quelconque des revendications précédentes, dans lequel le système de bus série de diffusion sous-marin comprend un ou plusieurs autres récipients sous-marins logeant un ou plusieurs desdits autres noeuds (22, 23).

12. Le système de bus série de diffusion sous-marin selon l'une quelconque des revendications précédentes, dans lequel les autres noeuds (22, 23) raccordés au bus série de diffusion (30) sont des noeuds de capteur.

13. Le système de bus série de diffusion sous-marin selon l'une quelconque des revendications précédentes, comprenant en outre un bus d'alimentation électrique (35), le noeud sous-marin et les autres noeuds raccordés au bus série de diffusion (30) étant alimentés en énergie électrique par le bus d'alimentation électrique (35).

14. Un procédé de terminaison d'un bus série de diffusion (30) d'un système de bus série de diffusion sous-marin comprenant un bus série de diffusion (30) possédant une première ligne de signal (31) et une deuxième ligne de signal (32), un ou plusieurs noeuds (22, 23) raccordés en parallèle à la première ligne de signal (31) et à la deuxième ligne de signal (32) du bus série de diffusion (30), chaque noeud (22, 23) raccordant la première ligne de signal à la deuxième ligne de signal par l'intermédiaire d'une impédance de noeud (13), d'un noeud sous-marin (21) raccordé à la première ligne de signal (31) et à la deuxième ligne de signal (32) et terminant le bus série de diffusion (30), le noeud sous-marin (21) étant un noeud maître placé à l'intérieur d'un récipient sous-marin (50) et les un ou plusieurs noeuds (22, 23) étant placés à l'extérieur du récipient sous-marin (50), le procédé comprenant les étapes suivantes :

    - la détermination d'un nombre (n) de noeuds (22, 23) raccordés au bus série de diffusion (30) et placés à l'extérieur du récipient sous-marin (50),
    - l'ajustement d'une impédance (11) du noeud sous-marin (21) placé à l'intérieur du récipient sous-marin (50) conformément au nombre déterminé de noeuds raccordés (22, 23),

l'étape d'ajustement de l'impédance (11) étant exécutée de sorte que l'impédance totale sur le bus série de diffusion (30) corresponde à une impédance de bus prédéterminée ($R_T$) à laquelle le bus série de diffusion doit être actionné.

# FIG 1   PRIOR ART

FIG 2

EP 2 726 997 B1

15

## FIG 3

RTH/RTL

10

11

15

12

CAN-H/CAN-L

31/32

## FIG 4

RTH/RTL

10

17

11

12

CAN-H/CAN-L

31/32

EP 2 726 997 B1

# FIG 5

# FIG 6

Start

Connect/Disconnect node to/from broadcast serial bus — 61

Measure current on power bus — 62

Determine number of nodes connected to broadcast serial bus from measured current — 63

Determine impedance required for termination of broadcast serial bus to obtain a total impedance of the broadcast serial bus that matches the predetermined bus impedance — 64

Adjust impedance of subsea node to the determined required impedance to obtain desired total bus impedance — 65

End

**EP 2 726 997 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 10261386 A1
- DE 19854117 A1